## Europäisches Patentamt

## European Patent Office

## Office européen des brevets

(11) Numéro de publication: **0 055 650**
**B1**

(12) **FASCICULE DE BREVET EUROPEEN**

(45) Date de publication du fascicule du brevet:
**14.11.84**

(21) Numéro de dépôt: **81401969.1**

(22) Date de dépôt: **09.12.81**

(51) Int. Cl.³: **H 04 R 19/04,** H 04 M 1/60,
H 03 F 3/185

(54) Circuit de liaison d'un microphone actif, en particulier à électret, à un circuit de transmission téléphonique.

(30) Priorité: **31.12.80 FR 8027891**

(43) Date de publication de la demande:
**07.07.82 Bulletin 82/27**

(45) Mention de la délivrance du brevet:
**14.11.84 Bulletin 84/46**

(84) Etats contractants désignés:
**DE GB IT NL SE**

(56) Documents cités:
**CH - A - 583 489**
**GB - A - 1 084 018**
**US - E - 28 596**

**RADIO MENTOR, vol. 33, no. 7, juillet 1978 Berlin, DE G. BORE: "Transistorbestückte Kondensator-Mikrofone in Niederfrequenz-Schaltung", pages 528-532**
**RADIO MENTOR ELECTRONIC, vol. 38, no. 8, août 1972 Berlin, DE H.J. GRIESE: "Elektret-Mikrofonkapseln", pages 377-379**
**JOURNAL OF THE AUDIO ENGINEERING SOCIETY, vol. 22, no. 2, mars 1974 New York, US J.R. NELSON: "Electret Microphone and Preamplifier Combination for Experimental Telephone Handset Use", pages 100-102**

(73) Titulaire: **THOMSON-CSF TELEPHONE, 146, Boulevard de Valmy, F-92707 Colombes (FR)**

(72) Inventeur: **Guillou, Denis, THOMSON-CSF SCPI 173, bld. Haussmann, F-75360 Paris Cedex 08 (FR)**

(74) Mandataire: **Chaverneff, Vladimir et al, THOMSON-CSF SCPI 173, Bld Haussmann, F-75379 Paris Cedex 08 (FR)**

## Description

La présente invention se rapporte à un circuit de liaison d'un microphone actif, en particulier à électret, à un circuit de transmission téléphonique.

Les microphones de combinés téléphoniques utilisés jusqu'à présent sont du type à charbon. Ces microphones sont simples à réaliser et peu coûteux, mais leurs caractéristiques électriques sont médiocres, et on tend à les remplacer par des microphones d'autres types, en particulier des microphones actifs tels que des microphones dits à effet électret, et appelés plus simplement par la suite microphones à électret.

Les microphones à électret sont des microphones du type actif parce qu'ils utilisent une énergie extérieure pour pouvoir délivrer un signal électrique correct, cette énergie servant à alimenter non pas le microphone proprement dit, mais le transistor adaptateur d'impédance qui est inclus dans le boîtier du microphone.

Le boîtier du microphone peut comporter soit deux soit trois bornes de raccordement extérieur. Les conducteurs de raccordement du boîtier peuvent être reliés soit en montage asymétrique qui est le plus couramment utilisé dans diverses applications, soit en montage symétrique flottant ou non flottant, c'est-à-dire relié à un potentiel de référence ou non. Dans le cas de l'application à la téléphonie, le conducteur de raccordement du microphone doit être à deux fils, et en montage symétrique, de préférence non flottant.

On connaît d'après l'article de G. Boré paru aux pp. 528-532 de la revue «Radio Mentor», vol. 33, N° 7, de juillet 1967, des circuits de liaison d'un microphone actif, mais tous ces circuits connus nécessitent un câble blindé, dont l'utilisation ne peut être envisagée avec un combiné téléphonique. En outre, le boîtier du microphone pour ces circuits comporte un amplificateur situé entre le microphone et le circuit de liaison.

La présente invention a pour objet un circuit de liaison d'un microphone actif, en particulier à électret, à un circuit de transmission téléphonique, au moyen d'un conducteur de raccordement à deux fils non blindés. Un tel circuit a été décrit dans l'article de J.R. Nelson: «Electret Microphone and Preamplifier Combination for Experimental Telephone Handset Use», pp. 100-102, paru dans le «Journal of the Audio Enginering Society», vol. 22, N° 2, mars 1974 à New York.

Le circuit de liaison conforme à la présente invention est caractérisé par le fait que chacun des deux fils d'une extrémité dudit conducteur de raccordement est relié à des bornes de raccordement extérieur du boîtier du microphone, et que chacun des deux fils de l'autre extrémité est relié, d'une part, par l'intermédiaire d'un condensateur, à une entrée d'un circuit à amplificateur différentiel et, d'autre part, par l'intermédiaire d'une résistance, à l'une des bornes d'une source d'alimentation appropriée d'un transistor adaptateur d'impédance, réduisant l'impédance du microphone, contenu dans le boîtier du microphone. Ce circuit permet d'alimenter de façon simple le transistor adaptateur d'impédance contenu dans le boîtier du microphone, et permet également l'interchangeabilité des microphones de provenances différentes. L'une des bornes de la source d'alimentation est de préférence reliée à un potentiel de référence qui est avantageusement la masse.

Dans le cas où le boîtier du microphone actif comporte trois bornes de raccordement extérieur, on relie avantageusement deux de ces bornes soit directement entre elles, si elles ne sont pas reliées entre elles à l'intérieur du boîtier du microphone, soit par l'intermédiaire d'un condensateur de découplage, si ces deux bornes sont reliées entre elles par une résistance et, dans les deux cas, l'une de ces deux bornes et la troisième borne sont reliées audit conducteur de raccordement à deux fils.

Pour pouvoir rendre interchangeables les microphones de provenances différentes, on branche entre deux bornes, reliées audit conducteur de raccordement à deux fils, un circuit série à résistance et condensateur, la résistance étant avantageusement réglable.

La présente invention sera mieux comprise à l'aide de la description détaillée de plusieurs modes de réalisation, illustrés par les dessins annexés sur lesquels:

la fig. 1 est le schéma d'un circuit de raccordement, conforme à l'invention, d'un microphone actif à trois bornes sans liaison à l'intérieur de son boîtier;

la fig. 2 est le schéma d'un circuit de raccordement, conforme à l'invention, d'un microphone actif à trois bornes avec résistance de liaison à l'intérieur de son boîtier;

la fig. 3 est le schéma d'un circuit de raccordement, conforme à l'invention, d'un microphone actif à deux bornes, et

la fig. 4 est un schéma équivalent en courant alternatif des circuits des fig. 1 à 3.

Le microphone actif représenté sur les trois figures du dessin est un microphone du type dit à effet électret, mais pourrait aussi bien être d'un autre type. Sur les trois figures, on n'a pas représenté le circuit de transmission téléphonique auquel est raccordé le microphone, ce circuit étant celui habituellement utilisé et ne subissant aucune modification.

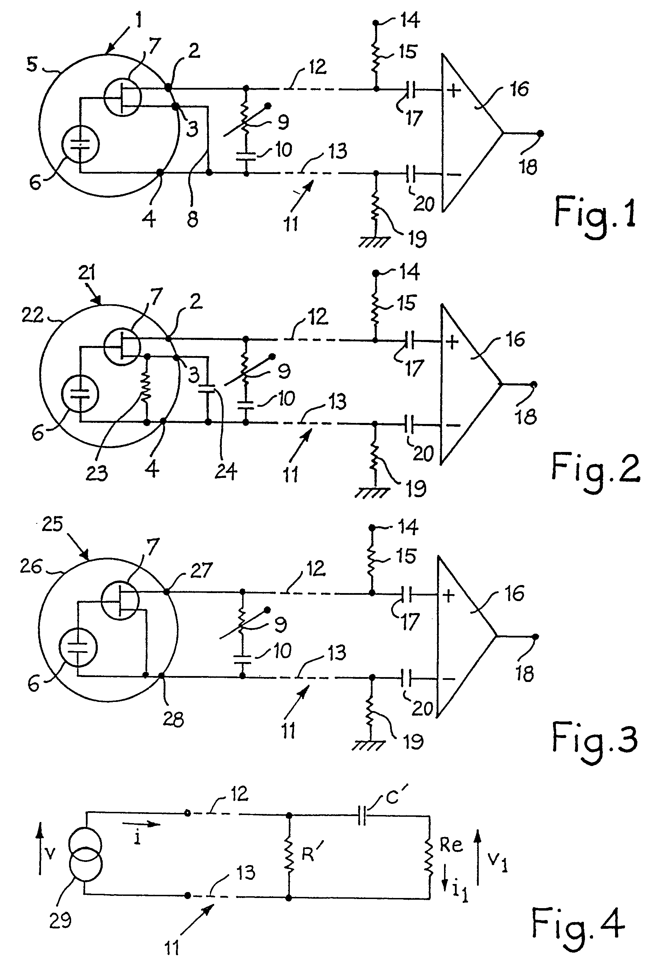

Le microphone 1 représenté sur la fig. 1 comporte trois bornes de raccordement extérieur, respectivement référencées 2, 3 et 4, disposées sur le boîtier 5 de ce microphone. Le boîtier 5 du microphone 1 renferme une capsule 6 à membrane électret et un transistor 7 à effet de champ. Le drain du transistor 7 est relié à la borne 2, sa source est reliée à la borne 3, et sa porte est reliée à une électrode de la capsule 6 dont l'autre électrode est reliée à la borne 4.

On relie, extérieurement au boîtier 5, la borne 3 à la borne 4 par un conducteur 8. La borne 2 est reliée, extérieurement au boîtier 5, à la borne 4 par un circuit série comprenant une résistance ajustable 9 et un condensateur de forte valeur 10.

L'ensemble des éléments décrits ci-dessus est logé dans un combiné téléphonique (non représenté) à la place du microphone classique à charbon.

Les bornes 2 et 4 sont reliées chacune à un fil d'un conducteur de raccordement 11 à deux fils respectivement référencés 12, 13. Le conducteur 11 fait partie du cordon (non représenté) à quatre fils reliant le combiné téléphonique à son poste téléphonique, les deux autres fils étant ceux correspondant à l'écouteur de ce combiné.

Le fil 12 du conducteur 11 est relié, dans le poste téléphonique, d'une part, à une borne 14 par l'intermédiaire d'une résistance 15 et, d'autre part, à l'entrée non inverseuse d'un amplificateur différentiel 16 par l'intermédiaire d'un condensateur 17. La borne 14 est reliée à un pôle d'une source d'alimentation appropriée (non représentée) du transistor 7 dont l'autre pôle est relié à la masse. La sortie 18 de l'amplificateur 16 est reliée au circuit habituel de transmission téléphonique (non représenté). Le fil 13 du conducteur 11 est relié, dans le poste téléphonique, d'une part, à la masse par l'intermédiaire d'une résistance 19 et, d'autre part, à l'entrée inverseuse de l'amplificateur 16 par l'intermédiaire d'un condensateur 20. De façon avantageuse, les valeurs des résistances 15 et 19 sont égales entre elles, et les valeurs des condensateurs 17 et 20 sont égales entre elles.

On a représenté sur la fig. 2 le schéma d'un circuit de raccordement pour un microphone 21 à trois bornes dont le boîtier 22 comporte, outre la capsule à électret 6 et le transistor à effet de champ 7, branchés de la même façon que dans le circuit de la fig. 1, une résistance 23 branchée entre les bornes 3 et 4. Pour compenser l'atténuation du signal produit par la capsule 6, atténuation due à la résistance 23, on branche, à l'extérieur du boîtier 22, entre les bornes 3 et 4, un condensateur 24 compensant pratiquement complètement cette atténuation dans la bande de fréquences téléphoniques considérées. Les éléments reliés aux bornes 2 et 4 du microphone 21 sont identiques à ceux reliés aux bornes 2 et 4 du microphone 1 du circuit de la fig. 1, et portent les mêmes références numériques, à savoir les éléments 9 à 20.

On a représenté sur la fig. 3 le schéma d'un circuit de raccordement pour un microphone 25 à deux bornes de raccordement extérieur. Le boîtier 26 du microphone 25 comporte deux bornes de raccordement extérieur 27 et 28, et renferme également une capsule à électret 6 et un transistor à effet de champ 7. Le drain du transistor 7 est relié à la borne 27, sa porte est reliée à une électrode de la capsule 6 dont l'autre électrode est reliée à la source du transistor 7 et à la borne 28. Les éléments reliés aux bornes 27 et 28 du microphone 25 sont identiques à ceux reliés aux bornes 2 et 4 du microphone 1 du circuit des fig. 1 et 2, et portent les mêmes références numériques, à savoir les éléments 9 à 20.

On va maintenant examiner le fonctionnement du circuit décrit ci-dessus. Du point de vue du fonctionnement en courant continu, une source de tension d'alimentation branchée entre la borne 14 et la masse alimente le transistor *via* les résistances 15 et 19 et la ligne 11. Les condensateurs 17 et 20 isolent les entrées de l'amplificateur 16 par rapport à cette source de tension. Dans le circuit de la fig. 2, le courant d'alimentation du transistor 7 passe également par la résistance 23 de la valeur de laquelle il faut tenir compte dans le calcul des valeurs des résistances 15 et 19.

Du point de vue du fonctionnement en courant alternatif, les circuits des fig. 1 à 3 sont pratiquement identiques, étant donné que, dans le circuit de la fig. 2, l'effet d'atténuation de la résistance 23 est pratiquement compensé par le condensateur 24, comme précisé ci-dessus.

On a représenté sur la fig. 4 le schéma équivalent, en courant alternatif, du circuit de raccordement de l'invention. Sur ce schéma, le microphone 1, 21 ou 25 a été symbolisé par un générateur de courant 29. En effet, le transistor 7, utilisé en adaptateur d'impédance comme dans d'autres types de microphones actifs, constitue un générateur de courant commandé par la tension délivrée par la membrane électret. On appelle v la tension délivrée par le microphone 29, et i le courant qu'il produit. Soit R' la résistance équivalant aux résistances 15 et 19. Du point de vue du microphone, les deux résistances 15 et 19 sont en série, et R' représente donc la somme de leurs valeurs. La résistance R' est branchée entre les deux fils 12, 13 du conducteur 11 supposé de résistance négligeable vis-à-vis de R', ce qui est le cas en pratique. Soit C' le condensateur équivalent aux condensateurs 17 et 20. Vus du microphone, les condensateurs 17 et 20 sont en série. En pratique, on choisit les condensateurs 17 et 20 de valeurs égales, et la valeur de C' est donc alors égale à la moitié de la valeur de l'un des condensateurs 17 ou 20. Soit Re la résistance d'entrée de l'amplificateur 16. Sur le schéma équivalent de la fig. 4, C' et Re sont en série et sont branchés en parallèle sur R'. On appelle $v_1$ la tension aux bornes de Re et $i_1$ le courant traversant Re. Pour la première partie de ces explications, on néglige l'action de la résistance 9 et du condensateur 10.

Si on appelle $\Omega = j2\pi f$, f étant la fréquence du courant alternatif produit par le microphone, et si on appelle a la pente du transistor 7 (exprimée en milliampères par volt par exemple), on trouve aisément que le transfert en courant $i_1/i$ du circuit de la fig. 4 s'écrit:

$$\frac{i_1}{i} = \frac{R'C'\Omega}{1 + (Re + R')\,C'\Omega} \qquad \text{avec } i_1 = \frac{v_1}{Re}$$
$$\text{et } i = a \cdot v$$

et le transfert en tension $\dfrac{v_1}{v}$ de ce circuit s'écrit:

$$\frac{v_1}{v} = \frac{aReR'C'\Omega}{1 + (Re + R')\,C'\Omega}$$

On voit ainsi que l'on peut facilement ajuster l'efficacité du microphone soit en agissant sur la pente a du transistor 7, c'est-à-dire en choisissant un transistor de caractéristiques appropriées, soit, et surtout, en agissant sur la valeur de la résistance Re. En effet, la valeur R' est déjà déterminée en fonction de la tension de la source d'alimentation reliée à la borne 14 et, pour des raisons pratiques et économiques, il est préférable de garder les condensateurs 17 et 20 fixes et de valeur relativement élevée.

En outre, le circuit de l'invention permet de régler la courbe de réponse en fréquence du microphone en agissant sur les valeurs des éléments du filtre passe-haut constitué par R', C' et Re.

Dans un exemple de réalisation, les valeurs des différents éléments du circuit étaient, pour les résistances 15 et 19 : 1,5 kΩ environ chacune ; pour les condensateurs 17 et 20 : 330 nF environ chacun, la résistance d'entrée de l'amplificateur 16 étant de 200 Ω environ, et la source d'alimentation du transistor 7 ayant une tension de 5 V environ.

Pour des raisons de diversification d'approvisionnement en microphones, il est intéressant de pouvoir remplacer un microphone d'une certaine provenance par un autre sans modifier le montage. Cela veut dire que les microphones doivent avoir une efficacité constante, quelle que soit leur provenance. A cet effet, on branche la résistance 9 et le condensateur 10 aux bornes des microphones, comme indiqué ci-dessus. Le condensateur 10 est simplement un condensateur d'isolation galvanique, afin que tout le courant fourni par la source d'alimentation branchée entre la borne 14 et la masse passe par le transistor 7. La valeur du condensateur 10 est donc choisie pour que son impédance, aux fréquences transmises, soit négligeable vis-à-vis de la valeur de la résistance 9.

Du point de vue du microphone, et en courant alternatif, la résistance 9 est en parallèle avec la résistance R'. On peut donc facilement calculer la valeur de la résistance 9 pour obtenir une efficacité donnée du microphone, en utilisant la formule de transfert en tension donnée ci-dessus. De façon avantageuse, la résistance 9 est ajustable.

En conclusion, le circuit de raccordement de l'invention permet d'utiliser, dans un combiné téléphonique, un microphone de bonne qualité tout en conservant le cordon de raccordement habituel entre le combiné et le poste téléphonique, et d'obtenir le même niveau de signal, quelle que soit la provenance du microphone.

## Revendications

1. Circuit de liaison d'un microphone actif, en particulier à électret, à un circuit de transmission téléphonique, au moyen d'un conducteur de raccordement à deux fils non blindés, caractérisé par le fait que chacun des deux fils d'une extrémité dudit conducteur de raccordement (11) est relié à des bornes de raccordement extérieur du boîtier du microphone (5, 22, 26) et que chacun des deux fils de l'autre extrémité est relié, d'une part, par l'intermédiaire d'un condensateur (17, 20), à une entrée d'un circuit à amplificateur différentiel (16) et, d'autre part, par l'intermédiaire d'une résistance (15, 19), à l'une des bornes d'une source d'alimentation appropriée d'un transistor adaptateur d'impédance (7), réduisant l'impédance du microphone, contenu dans le boîtier du microphone.

2. Circuit de liaison selon la revendication 1, caractérisé par le fait que l'une des bornes précitées de la source d'alimentation est reliée à la masse.

3. Circuit de liaison selon l'une des revendications précédentes, pour un microphone à trois bornes de raccordement extérieur non reliées entre elles à l'intérieur du boîtier du microphone, caractérisé par le fait que l'on relie directement entre elles deux de ces bornes (3, 4), à l'intérieur du boîtier, l'une de ces deux bornes (4) et la troisième (2) étant reliées audit conducteur de raccordement à deux fils.

4. Circuit de liaison selon l'une des revendications 1 ou 2, pour un microphone à trois bornes de raccordement extérieur dont deux sont reliées entre elles par une résistance à l'intérieur du boîtier du microphone, caractérisé par le fait que l'on relie extérieurement au boîtier ces deux bornes (3, 4) par un condensateur de découplage (24), l'une de ces deux bornes (4) et la troisième (2) étant reliées audit conducteur de raccordement à deux fils.

5. Circuit de liaison selon l'une des revendications précédentes, caractérisé par le fait que l'on branche entre les bornes de raccordement extérieur du boîtier du microphone reliées au conducteur de raccordement un circuit série à résistance et condensateur (9, 10).

6. Circuit de liaison selon la revendication 5, caractérisé par le fait que ladite résistance du circuit série est réglable.

7. Circuit de liaison selon l'une des revendications 5 ou 6, caractérisé par le fait que l'impédance du condensateur du circuit série, aux fréquences transmises, est négligeable vis-à-vis de la valeur de la résistance de ce même circuit série.

8. Circuit de liaison selon l'une quelconque des revendications précédentes, caractérisé par le fait que les résistances reliant le conducteur de raccordement aux bornes de la source d'alimentation ont chacune pour valeur 1500 Ω environ, que les condensateurs reliant le conducteur de raccordement à l'amplificateur différentiel ont chacun pour valeur 330 nF environ, la résistance d'entrée de l'amplificateur différentiel étant de 200 Ω environ, et la source de tension ayant une tension de 5 V environ.

## Claims

1. Connection circuit for connecting an active microphone, in particular an electret microphone, to a telephone transmission circuit through a connection cable having two unscreened wires, characterized by the fact that each of the two wires of one end of said connection cable (11) is connected to connection terminals outside of the microphone housing (5, 22, 26) and in that each of the two wires of the other end is connected, on the one hand and trough a capacitor (17, 20), to one input of a differential amplifier circuit (16) and, on the other hand and through a resistor (15, 19), to one of the terminals of an appropriate supply source of an impedance adaptation transistor (7) reducing the impedance of the microphone and contained within the microphone housing.

2. Connection circuit according to Claim 1, characterized by the fact that of the above-mentioned terminals of the supply source is connected to ground.

3. Connection circuit according to any of the preceding claims for a microphone having three outer connection terminals not interconnected within the microphone housing, characterized by the fact that two of these terminals (3, 4) are directly interconnected inside the housing, one of these terminals (4) and the third (2) of them being connected to the two-wire connection cable.

4. Connection circuit according to any of Claims 1 or 2, for a microphone having three outer connection terminals two of which are interconnected inside the microphone housing by a resistor, characterized by the fact that these two terminals (3, 4) are interconnected outside the housing by a decoupling capacitor (24), one of these two terminals (4) and the third (2) of them being connected to the two-wire connection cable.

5. Connection circuit according to any of the preceding claims, characterized by the fact that a series circuit with a resistor and a capacitor (9, 10) is connected between the terminals for connection outside of the microphone housing and which are connected to the connection cable.

6. Connection circuit according to Claim 5, characterized by the fact that the resistor of the series circuit is adjustable.

7. Connection circuit according to any of Claims 5 or 6, characterized by the fact that the impedance of the series circuit capacitor is negligible at the transmitted frequencies against the resistance value of the same series circuit.

8. Connection circuit according to any of the preceding claims, characterized by the fact that the resistors connecting the connection cable to the terminals of the supply source each have a value of about 1500 $\Omega$, that the capacitors connecting the connection cable to the differential amplifier each have a value of about 330 nF, the input resistance of the differential amplifier being about 200 $\Omega$, and the voltage source having a voltage of about 5 V.

**Patentansprüche**

1. Anschlussschaltung für ein aktives Mikrophon, insbesondere Elektretmikrophon, zum Anschliessen an einen Telefonübertragungskreis, mittels einer Anschlussleitung, die zwei ungeschirmte Drähte enthält, dadurch gekennzeichnet, dass jeder der beiden Drähte eines Endes der Anschlussleitung (11) mit ausserhalb des Mikrophongehäuses (5, 22, 26) angeordneten Anschlussklemmen verbunden ist und dass jeder der beiden Drähte des anderen Endes einerseits über einen Kondensator (17, 20) mit einem Eingang einer Differenzverstärkerschaltung (16) und andrerseits über einen Widerstand (15, 19) mit einem der Anschlüsse einer geeigneten Versorgungsquelle für einen Impedanzanpassungstransistor (7), welcher die Mikrophonimpedanz vermindert und in dem Mikrophongehäuse enthalten ist, verbunden ist.

2. Anschlussschaltung nach Anspruch 1, dadurch gekennzeichnet, dass einer der genannten Anschlüsse der Versorgungsquelle mit Masse verbunden ist.

3. Anschlussschaltung nach einem der vorstehenden Ansprüche für ein Mikrophon, dessen drei Aussenanschlussklemmen im Inneren des Mikrophongehäuses nicht miteinander verbunden sind, dadurch gekennzeichnet, dass zwei dieser Klemmen (3, 4) im Inneren des Gehäuses direkt miteinander verbunden sind, wobei eine dieser Klemmen (4) und die dritte von ihnen (2) mit der Zweidraht-Anschlussleitung verbunden sind.

4. Anschlussschaltung nach einem der beiden Ansprüche 1 oder 2 für ein Mikrophon mit drei Aussenanschlussklemmen, wovon zwei miteinander über einen Widerstand im Inneren des Mikrophongehäuses verbunden sind, dadurch gekennzeichnet, dass diese zwei Klemmen (3, 4) ausserhalb des Gehäuses durch einen Entkopplungskondensator (24) miteinander verbunden sind, während eine dieser zwei Klemmen (4) und die dritte (2) von ihnen mit der Zweidraht-Anschlussleitung verbunden sind.

5. Anschlussschaltung nach einem der vorstehenden Ansprüche, dadurch gekennzeichnet, dass zwischen die ausserhalb des Mikrophongehäuses liegenden und mit der Anschlussleitung verbundenen Anschlussklemmen eine Reihenschaltung aus einem Widerstand und einem Kondensator (9, 10) geschaltet ist.

6. Anschlussschaltung nach Anspruch 5, dadurch gekennzeichnet, dass der genannte Widerstand der Reihenschaltung einstellbar ist.

7. Anschlussschaltung nach einem der beiden Ansprüche 5 oder 6, dadurch gekennzeichnet, dass die Impedanz des Kondensators der Reihenschaltung bei den übertragenen Frequenzen vernachlässigbar ist gegenüber dem Widerstandswert dieser selben Reihenschaltung.

8. Anschlussschaltung nach einem der vorstehenden Ansprüche, dadurch gekennzeichnet, dass die Widerstände, welche die Anschlussleitung mit den Klemmen der Versorgungsquelle verbinden, jeweils einen Wert von etwa 1500 $\Omega$ aufweisen, dass die Kondensatoren, welche die Anschlussleitung mit dem Differenzverstärker verbinden, jeweils einen Wert von etwa 330 nF aufweisen und dass der Eingangswiderstand des Differenzverstärkers etwa 200 $\Omega$ beträgt, während die Spannungsquelle eine Spannung von etwa 5 V abgibt.

Fig.1

Fig.2

Fig.3

Fig.4